# EUROPEAN PATENT APPLICATION

(11) **EP 4 685 503 A1**
(43) Date of publication of application: **28.01.2026**
(21) Application number: 24826086.1
(22) Date of filing: 08.04.2024
(51) Int. Cl.: G01R 31/367, G01R 31/396, G01R 31/385, G01R 31/382, G01R 31/392, G01R 19/00, G01R 31/371, H02J 7/00, H01M 10/42, H01M 10/48

(54) **SIMULATOR OF BATTERY PACK**

(30) Priority: 21.06.2023 KR 20230079553
(71) Applicant: LG Energy Solution, Ltd., Seoul 07335 (KR)
(72) Inventor: HAN, Dongwon, Daejeon 34122 (KR); KIM, Youngkyo, Daejeon 34122 (KR); KIM, Youngsoo, Daejeon 34122 (KR); CHAE, Seung Hee, Daejeon 34122 (KR); JANG, Museong, Daejeon 34122 (KR)
(74) Representative: Plasseraud IP
(86) International application number: PCT/KR2024/004671
(87) International publication number: WO 2024/262762

(57) **Abstract**

A battery pack simulator according to one embodiment of the present disclosure simulates a battery pack including a cell module assembly(CMA) including a plurality of battery cell stacks and a battery management system(BMS), and includes a plurality of BMS simulation units that simulate the BMS, wherein each BMS simulation unit manages and controls the state and operation of the battery pack to be simulated.

## Description

### [TECHNICAL FIELD]

### Cross Citation with Related Application(s)

This application claims the benefit of Korean Patent Application No. 10-2023-0079553 filed on June 21, 2023 in the Korean Intellectual Property Office, the disclosures of which are incorporated herein by reference in their entirety.

The present disclosure relates to a battery pack simulator, and more specifically, to a battery pack simulator which can be used for battery pack inspection, such as EOL(End-Of-Line) inspection.

### [BACKGROUND]

Recently, as the demand for portable electronic products such as notebook computers, video cameras, and mobile phones, and energy storage system (ESS) has been rapidly increasing, and electric vehicles, energy storage batteries, robots, satellites, etc. have been developed in earnest, a high-performance secondary battery which can be repeatedly charged and discharged are being actively researched.

Currently, commercially available secondary batteries include a nickel cadmium battery, a nickel hydrogen battery, a nickel zinc battery, a lithium secondary battery, and the like, and among them, the lithium secondary battery has come into the spotlight because it has advantages, for example, hardly exhibiting memory effects compared to nickel-based secondary batteries and thus being freely charged and discharged, and having very low self-discharge rate and high energy density.

Meanwhile, these battery packs are equipped with a CMA(Cell Module Assembly) and a BMS(Battery Management System), but a process is required to verify (inspect) their functions in advance to ensure that they operate properly during actual battery pack operation.

When performing an inspection with an actual battery pack, the battery packs must be periodically replaced every predetermined period (e.g., once every few months) due to limitations in terms of battery cell life, SOC, and other factors. Therefore, significant costs are incurred in performing an inspection using an actual battery pack. To solve this problem, a method of inspecting a battery pack by simulating a virtual battery pack is needed.

In addition, a plurality of battery packs can be realized in various ways by varying the number and connection method, but there is a need to develop a method capable of inspecting battery packs in a simple manner with one (or a few) simulator without producing corresponding simulators one by one.

### [DETAILED DESCRIPTION OF THE INVENTION]

### [Technical Problem]

It is an objective of the present disclosure to provide a battery pack simulator capable of performing inspection in a simpler and cost-saving manner when inspecting a plurality of battery packs.

However, the objective of the present disclosure is not limited to the aforementioned one, and may be extended in various ways within the scope of the technical idea included in the present disclosure.

### [Technical Solution]

According to one embodiment of the present disclosure, there is provided a battery pack simulator which simulates a battery pack including a cell module assembly(CMA) including a plurality of battery cell stacks and a battery management system(BMS), and which comprises a plurality of BMS simulation units that simulate the BMS, wherein each BMS simulation unit manages and controls the state and operation of the battery pack to be simulated.

The plurality of BMS simulation units are connected to each other in series and/or parallel, and are integrated and disposed on a substrate, and each of the plurality of BMS simulation units can be selectively connected by a switch or a selector so as to enable adjustment of the number of battery packs to be simulated and of the series and/or parallel connections.

Each of the plurality of BMS simulation units can be electrically connected to a cell simulation unit for simulating the CMA, and manages and controls the state and operation of the cell simulation unit that performs the simulating, the battery pack simulator further comprises a plurality of connectors that electrically connect each BMS simulation unit and each cell simulation unit, and the plurality of connectors may be integrated and disposed on the substrate.

Each BMS simulation unit and each cell simulation unit may be detachable from the substrate.

The battery pack simulator further comprises the plurality of cell simulation units that simulate the CMA, wherein the plurality of cell simulation units may be integrated and disposed on the substrate.

Each cell simulation unit may be detachable from the substrate.

An inspection device that inspects the battery pack can be directly or indirectly connected to the BMS simulation unit.

A RBMS (Rack Battery Management System) that wholly manages and controls the plurality of battery packs is connected directly or indirectly to the BMS simulation unit, and an inspection device that inspects the battery packs may be connected to the RBMS.

The BMS simulation unit receives state information of a battery pack including at least one of the voltage of the battery cell in the CMA, the voltage of the battery pack, the current of the battery pack, and the temperature of the battery pack, and may transmit the information to the inspection device.

The BMS simulation unit receives state information of a battery pack including at least one of the voltage of the battery cell in the CMA, the voltage of the battery pack, the current of the battery pack, and the temperature of the battery pack, and may change the information in conformity with inspection conditions or generate state information of the battery pack in conformity with inspection conditions.

The BMS simulation unit may comprise at least one of a cell voltage control unit that controls the output of individual battery cells, a pack voltage control unit that controls the output of pack voltage, a current control unit that controls the output of current, and a temperature control unit that controls the output of temperature.

The BMS simulation unit further comprises at least one of an SOH calculation unit that calculates an SOH estimate value, and a SOC calculation unit that calculates a SOC estimate value.

The BMS simulation unit may further comprise a defect determination unit that compares the cell voltage value, pack voltage value, current value, temperature value, SOH, or SOC with a predetermined reference value to determine whether the battery pack is defective or not.

The BMS simulation unit may further comprise an arithmetic unit that calculates the average value or deviation or remaining charge time for each of the cell voltage value, pack voltage value, current value, temperature value, SOH, and SOC.

The BMS simulation unit may comprise a transmission/reception unit that communicates between the cell simulation unit and the inspection device.

The battery pack simulators are provided in a plurality of numbers, and can be electrically connected in series or parallel between the battery pack simulators.

### [Advantageous Effects]

According to the present disclosure, in the process of battery pack inspection, a battery pack simulator that simulates a virtual battery pack can be used to perform inspections in a simple and cost-saving manner.

In addition, a plurality of battery packs are realized in various different ways by varying the numbers and/or connection methods, thereby capable of performing inspections in a simple manner with one (or a few) simulators.

The effects of the present disclosure are not limited to the effects mentioned above and additional other effects not described above will be clearly understood from the detailed description of the appended claims by those skilled in the art.

### [BRIEF DESCRIPTION OF THE DRAWINGS]

Fig. 1 schematically shows a case in which a plurality of typical battery packs P are provided;
Fig. 2 schematically shows a battery pack simulator according to an embodiment of the present disclosure;
Fig. 3 shows detailed components of the BMS simulation unit provided in the battery pack simulator of Fig. 2;
Fig. 4 shows a battery pack simulator according to another embodiment of the present disclosure, which is a modification of Fig. 2;
Fig. 5 shows a battery pack simulator according to yet another embodiment of the present disclosure, which is another modification of Fig. 2; and
Figs. 6 to 8 respectively show a case where the simulators of Figs. 2, 4 and 5 are connected in a plurality of numbers.

### [DETAILED DESCRIPTION OF THE EMBODIMENTS]

Hereinafter, various embodiments of the present disclosure will be described in detail with reference to the accompanying drawings so that those skilled in the art can easily carry out them. The present disclosure may be modified in various different ways, and is not limited to the embodiments set forth herein.

Portions that are irrelevant to the description will be omitted to clearly describe the present disclosure, and like reference numerals designate like elements throughout the description.

Hereinafter, exemplary embodiments disclosed herein will be described in detail with reference to the accompanying drawings, but the same or similar components will be given the same reference numerals regardless of reference numerals, and a duplicated description thereof will be omitted.

The suffixes "modules" and/or "unit" for the components used in the following description are given or interchangeably used only to facilitate the writing of the specification, without necessarily indicating a distinct meaning or role of their own. In addition, in describing the embodiments disclosed in the present disclosure, when it is determined that the specific description of the related and already known technology may obscure the essence of the embodiments disclosed herein, the specific description will be omitted. Further, it is to be understood that the accompanying drawings are only intended to facilitate understanding of the embodiments disclosed herein, the technical spirit disclosed therein is not limited by the accompanying drawings, and the invention covers all modifications, equivalents or alternatives falling within the spirit and technical scope of the present disclosure.

The terms including ordinal numbers such as first, second, and the like may be used to describe various components, but the components are not to be limited by the terms. The terms may only be used for the purpose of distinguishing one component from another.

It is to be understood that when a component is referred to as being "connected" or "coupled" to another component, the component may be directly connected or coupled to the another component, but other components may be interposed therebetween. In contrast, it is to be understood that when a component is referred to as being "directly connected" or "directly coupled" to another component, no other component is interposed therebetween.

It will be further understood that the terms such as "comprise" or "have", when used in this specification, specify the presence of stated features, numbers, steps, operations, elements, parts, or combinations thereof, but do not preclude the presence or addition of one or more other features, numbers, steps, operations, elements, parts, or combinations thereof.

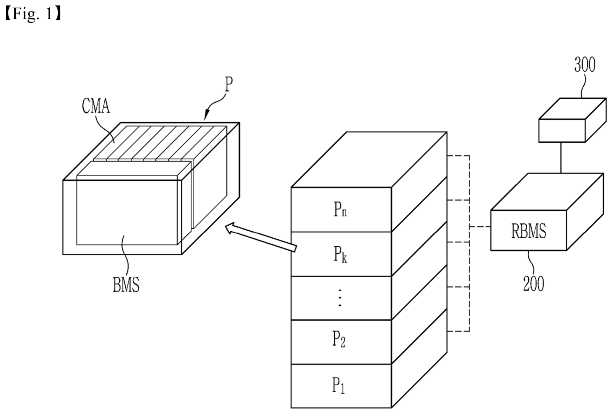

Fig. 1 schematically shows a case in which a plurality of typical battery packs P are provided. As shown in Fig. 1, it may be provided, for example, in a stacked form, but the present disclosure is not limited thereto, and without being necessarily stacked, it can be applied when inspecting a plurality of battery packs P. A plurality of battery packs P may be provided in n numbers of battery packs, wherein n is a natural number. Each battery pack P may include a plurality of CMAs (Cell Module Assemblies) and a BMS (Battery Management System) that manages the CMAs. The BMS may be separated from the battery pack P and connected to the outside, and may be integrated and formed in the inside of the battery pack P as shown in Fig. 1. The BMS may manage and/or control the state and/or operation of the CMA and a plurality of battery cells included in the CMA. For example, the BMS can monitor the voltage, current, temperature, and the like of the CMA.

In the present specification, BMS may mean, more specifically, PBMS (Pack BMS) in distinction from a RBMS (Rack BMS) described below, but for convenience of explanation, it is collectively referred to as "BMS."

A plurality of battery packs P may be wholly or partially connected in series or parallel. Further, the plurality of battery packs P are connected to a RBMS(Rack Battery Management System) 200. The RBMS 200 is electrically connected to the BMS of each battery pack P, and wholly manages and controls the plurality of battery packs P. For reference, the RBMS 200 and BMS are also referred to as master BMS and slave BMS, respectively. The RBMS 200 may be stacked at the uppermost end of a plurality of battery packs P, may be coupled to one surface of a plurality of battery packs P, or may be separated from the plurality of battery packs P and installed in a separate space. The method in which the RBMS is actually realized is not limited. Various inspection devices 300 can be coupled to the RBMS 200 to inspect the battery packs P.

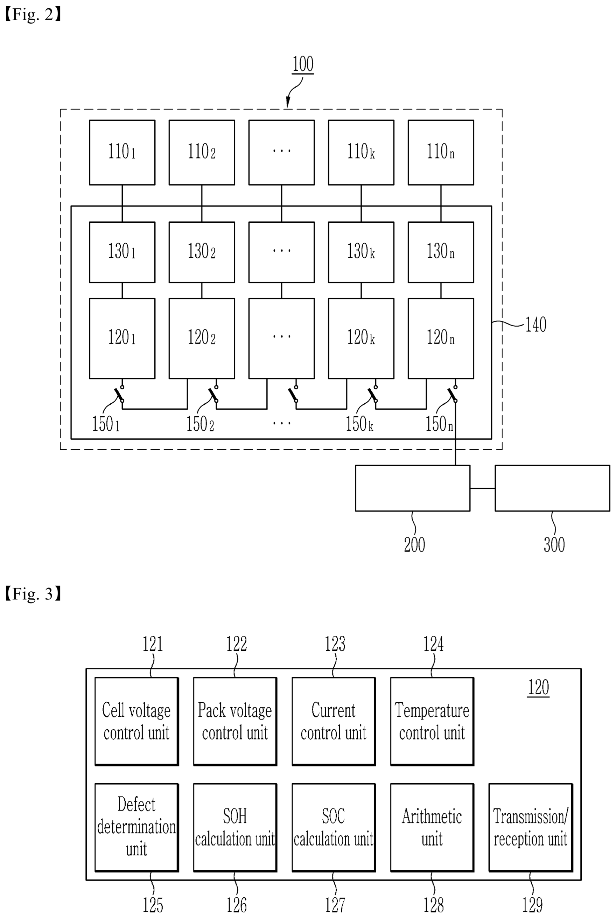

Fig. 2 schematically shows a battery pack simulator according to an embodiment of the present disclosure. Fig. 3 shows detailed components of the BMS simulation unit provided in the battery pack simulator of Fig. 2.

The battery pack simulator 100 of Fig. 2 simulates the BMS provided in each of the plurality of battery packs P of Fig. 1.

First, the battery pack simulator 100 includes a plurality of BMS simulation units 120. The plurality of BMS simulation units 120 may be electrically connected to the plurality of cell simulation units 110, respectively. In some cases, each of the plurality of BMS simulation units 120 may be connected to an actual battery cell stack or an actual battery pack.

In addition, the battery pack simulator 100 may further include a plurality of cell simulation units 110. Furthermore, the battery pack simulator 100 may include a plurality of connectors 130 that allow the plurality of BMS simulation units 120 to be connected to the plurality of cell simulation units 110, respectively.

Each of the cell simulation unit 110, the BMS simulation unit 120, and the connector 130 may be provided, for example, in n numbers, wherein n is a natural number. In Fig. 2, for convenience, the cell simulation units 110 are denoted in order from the left as 110₁, 110₂, ..., 110ₖ, 110ₙ. Wherein k is a natural number from 1 to n. Similarly, the BMS simulation units 120 are denoted as 120₁, 120₂, ..., 120ₖ, 120ₙ, the connectors 130 are also denoted as 130₁, 130₂, ..., 130ₖ, and 130ₙ. Wherein k is a natural number from 1 to n.

As shown exemplarily in Fig. 2, a plurality of BMS simulation units 120 and a plurality of connectors 130 may be integrated and disposed on the substrate 140, and a plurality of cell simulation units 110 may be electrically connected to a plurality of connectors 130, respectively. Alternatively, in some cases, a plurality of cell simulation units 110 may also be integrated and disposed on the substrate 140 of the battery pack simulator 100.

The cell simulation unit 110 is a circuit unit composed of an actual CMA and an equivalent circuit so as to simulate an actual CMA (cell module assembly). More specifically, it outputs data that realizes the spec of the CMA to be simulated, the driving state and driving conditions of the corresponding CMA, and the like. For example, it outputs the voltage value of the battery pack to be simulated, the current value of the battery pack, the temperature of the battery pack, the resistance value of the thermistor for temperature measurement, the voltage value of each battery cell of the CMA, and the like. For the configuration and function of the cell simulation unit 110, refer to the configuration and function of a typical cell simulation unit.

The BMS simulation unit 120 may receive input of the voltage value of the battery cell, the voltage value of the battery pack, the current value of the battery pack, the temperature value of the battery pack, the resistance value of the thermistor for temperature measurement, and the like from the cell simulation unit 110 electrically connected to the BMS simulation unit 120.

In addition, the BMS simulation unit 120 may generate state information of a battery pack including at least one of the voltage value of the battery cell in the CMA, the voltage value of the battery pack, the current value of the battery pack, and the temperature value of the battery pack in conformity with inspection (testing) conditions, and may change and adjust the values received from the cell simulation unit 110 in conformity with inspection (testing) conditions. For example, for various inspections by an inspection device 300, the value transferred from the cell simulation unit 110 may be arbitrarily changed in the BMS simulation unit 120 to a value corresponding to a defect in the battery pack. In some cases, for inspection under desired conditions in the inspection device 300, data such as individual cell voltage, pack voltage, current, or temperature for simulating under desired conditions may be input to the BMS simulation unit 120.

The BMS simulation unit 120 may manage and/or control the state and/or operation of the cell simulation unit 110. For example, the BMS simulation unit 120 may monitor and sense the voltage value, current value, temperature value, resistance value, and the like of the cell simulation unit 110, and the BMS simulation unit 120 may manage and/or control the state and/or operation of the cell simulation unit 110.

Further, the BMS simulation unit 120 may calculate parameters indicating the state of CMA, for example, SOC(State of Charge), SOH(State of Health), remaining charge time, and the like based on measured values such as cell voltage value, pack voltage value, current value, and temperature value which are input from the cell simulation unit 110. Further, it is possible to detect whether errors (defects) occurs from the voltage value of the battery cell, the voltage value of the battery pack, the current value of the battery pack, the temperature value of the battery pack, and the like which are received from the cell simulation unit 110.

Referring to Fig. 3, the BMS simulation unit 120 may include at least one of a cell voltage control unit 121 that controls the output of individual battery cells, a pack voltage control unit 122 that controls the output of pack voltage, a current control unit 123 that controls the output of current, and a temperature control unit 124 that controls the output of temperature. In addition, the BMS simulation unit 120 may include a defect determination unit 125 that determines whether the battery pack is defective, an SOH calculation unit 126 that calculates SOH, an SOC calculation unit 127 that calculates SOC, an arithmetic unit 128 and/or a transmission/reception unit 129 that communicates between the cell simulation unit 110, the RBMS 200, and the inspection device 300, based on the measured values such as cell voltage value, pack voltage value, current value, temperature value, and the like.

The cell voltage control unit 121, the pack voltage control unit 122, the current control unit 123, and the temperature control unit 124 respectively receive individual cell voltage, pack voltage, current, and temperature values, adjust and control in conformity with the desired inspection conditions and environments and transmit to the RBMS 200 and the inspection device 300. Alternatively, they may transmit control signals for individual cell voltage, pack voltage, current, and temperature values to the cell simulation unit 110 in conformity with the desired inspection conditions and environments.

The defect determination unit 125 compares the measured values of individual cell voltage, pack voltage, current, and temperature, which are the data to be inspected, with predetermined reference values to determine (diagnose) whether or not the battery pack is defective or not.

At this time, the cell voltage value, the pack voltage value, the current value, and the temperature value may be values received from the cell simulation unit 110, and in some cases, they may be values generated from the cell voltage control unit 121, the pack voltage control unit 122, the current control unit 123, and the temperature control unit 124 of the BMS simulation unit 120, or may be a value obtained by adjusting the value received from the cell simulation unit 110.

The defect determination unit 125 compares the cell voltage value, pack voltage value, current value, temperature value, SOH, SOC, etc. with a predetermined reference value, and when the data is determined to be a normal state value and not a defect, it can generate a first flag value declaring a normal state, and if the data is determined to be an abnormal state value corresponding to a defect, it can generate a second flag value declaring an abnormal state. The first flag value declaring a normal state may be, for example, "0", but the present disclosure is not limited thereto. Further, the second flag value declaring an abnormal state may be, for example, "1", but the present disclosure is not limited thereto. The second flag value may be designated as various predetermined values according to various abnormal states. That is, it may be designated as a single-digit binary number, but in some cases, it may be designated as various values as the values having multiple digits.

The SOH calculation unit 126 may calculate an SOH estimate value. For this purpose, the capacity of the battery cell stack can be estimated in order to predict the degree of battery degradation. Here, the capacity estimation of the battery cell stack can be performed in various ways. For example, the current and voltage received from the cell simulation unit 110 that simulates the battery pack can be applied to Ohm's law to indirectly calculate the internal resistance of the battery pack (i.e., cell simulation unit 110).

The SOC calculation unit 127 may calculate the SOC estimate value. For this purpose, for example, the SOC of the battery cell stack can be estimated using the capacity and current of the battery cell stack estimated from the SOH calculation unit 126.

The arithmetic unit 128 calculates the average and/or deviation, etc. using at least one of the data including the above-mentioned cell voltage, pack voltage, current, temperature, SOC, SOH, and the like. The calculated data may be transmitted to the RBMS 200 and/or the inspection device 300, and may be stored in a data storage device (not shown). Alternatively, the arithmetic unit 128 may calculate the remaining charge time.

The transmission/reception unit 129 transmits and receives data and commands so as to enable bidirectional communication between the cell simulation unit 110 - BMS simulation unit 120 - RBMS 200. The transmission/reception unit 129 may adopt a communication method used in PCB communication. The transmission/reception unit 129 can transmit data and commands using internal communication methods such as I2C, SMBus, CAN, UART, and SPI. The present disclosure is not limited to those described above, and various communication methods suitable for the environment in which the invention is realized can be adopted.

The BMS simulation unit 120 may further include a data storage device (not shown). The data storage device may be integrated into the BMS simulation unit 120, or may be provided externally and communicated wired or wirelessly. The data storage device may store data including the above-mentioned cell voltage, pack voltage, current, temperature, SOC, SOH, etc., and/or the average and/or deviation which calculates these data at the arithmetic unit 128.

As for each component of the above-mentioned BMS simulation unit 120, all of the components in conformity with the environment in which the invention is realized, and in conformity with the inspection purpose may be provided, and various variations and changes are possible, for example, only necessary components may be provided selectively.

The connector 130 electrically connects the cell simulation unit 110 and the BMS simulation unit 120. In the actual battery pack of Fig. 1, the CMA and BMS are electrically connected by busbars, wires, and the like. On the other hand, in the battery pack simulator 100 of Fig. 2, the BMS simulation unit 120, which is not the actual CMA and BMS, is electrically connected to the cell simulation unit 110, and compatibility is provided in the electrical connection between the BMS simulation unit 120 and the cell simulation unit 110. The connector 130 may include an input/output terminal, a switch, and the like. It is sufficient if the shape/structure of the connector 130 is realized to match with (correspond to) the shape/structure of the input/output unit of the cell simulation unit 110, and may be realized in various ways according to various environments in which the invention is realized.

Further, the battery pack simulator 100 may include a thermistor (not shown). In the present disclosure, the thermistor is not a temperature sensor, but provides a reference temperature for inspection whether the RBMS 200 is operating correctly. The thermistor may have a resistance of 10k ohms, corresponding to a reference temperature of, for example, 25 degrees Celsius. The thermistor may be disposed on the substrate 140, for example between the BMS simulation unit 120 and the RBMS 200, but the present disclosure is not limited thereto, and it is sufficient if it is provided in the battery pack simulator 100.

Further, the plurality of BMS simulation units 120 are electrically connected to the RBMS 200 that wholly manages and controls the plurality of battery packs P. A plurality of BMS simulation units 120 may be directly connected to the RBMS 200. Fig. 2 shows a case in which a plurality of BMS simulation units 120 are connected in series to simulate a case in which a plurality of actual battery packs P are connected in series.

In addition, when the switch 150 is further provided to simulate only a desired number of battery packs among the plurality of battery packs P, the switch 150 can be selectively turned on/off so that among the BMS simulation units 120 provided on the substrate 140, the BMS simulation units 120 can be electrically connected by a desired number to the RBMS 200. The present disclosure is not necessarily limited to the case where a plurality of battery packs P are connected, and in some cases, it may be possible to inspect a battery pack P with the switch 150. In Fig. 2, for convenience, the switches 150 are indicated in order from the left as 150₁, 150₂, ..., 150ₖ, and 150ₙ. Wherein k is a natural number from 1 to n.

Additionally, a plurality of battery packs P as shown in FIG. 1 may be realized in various numbers in an actual environment. At this time, even if a battery pack simulator 100 having a different number of BMS simulation units 120 in correspondence to a different number of battery packs P is not provided one by one, the switch 150 may be individually turned on/off to select all or part of the plurality of BMS simulation units 120 and connect them to the RBMS 200.

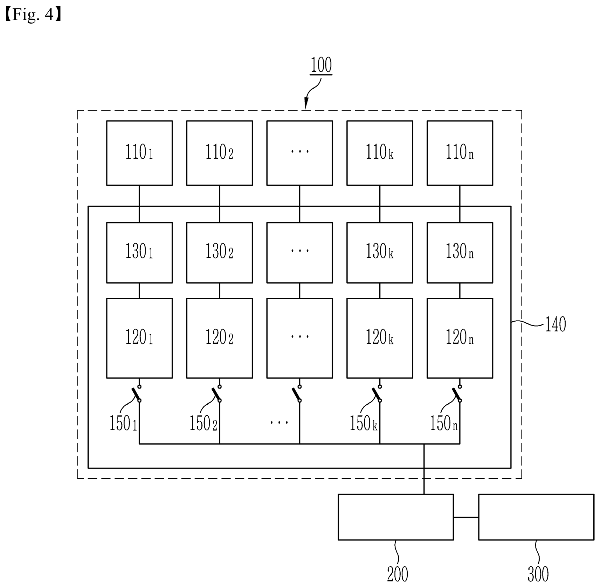

Fig. 4 shows a battery pack simulator according to another embodiment of the present disclosure, which is a modification of Fig. 2.

FIG. 4 illustrates a case in which a plurality of BMS simulation units 120 are connected in parallel in order to simulate a case in which a plurality of actual battery packs P are connected in parallel. For the components that overlap with those of Fig. 2, refer to those described above in Fig. 2 .

On the other hand, the present disclosure also allows a combination of Figs. 2 and 4. In addition, as shown in Figs. 2 and 4, the present disclosure is not limited to the case where all of the plurality of BMS simulation units 120 are connected in series and the case where all of the plurality of BMS simulation units 120 are connected in parallel, and various modifications and changes are possible, for example, some of the plurality of BMS simulation units 120 may be connected in series and the others may be connected in parallel.

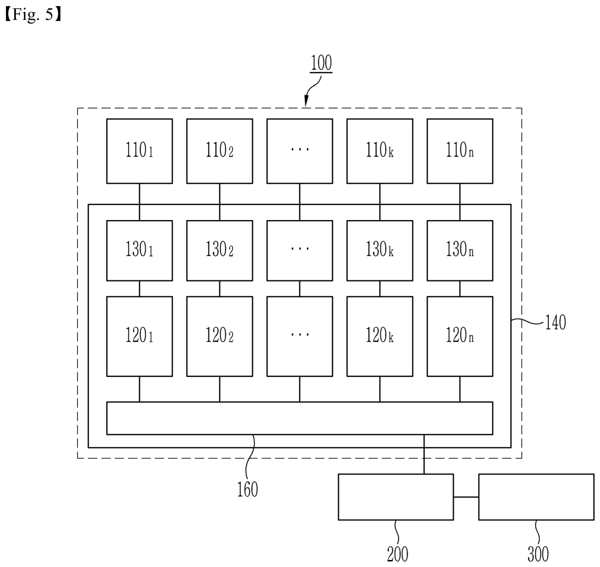

Fig. 5 shows a battery pack simulator according to yet another embodiment of the present disclosure, which is another modification of Fig. 2.

Meanwhile, as shown in Fig. 5, a plurality of BMS simulation units 120 may be indirectly connected to the RBMS 200 via the selector 160. The selector 160 is provided with wiring so as to enable serial and parallel connection between the plurality of BMS simulation units 120, for example, and it is connected with a switch between wirings. Therefore, all of the plurality of BMS simulation units 120 provided on the substrate 140 may be electrically connected to the RBMS 200, and among the plurality of BMS simulation units 120 provided on the substrate 140, the BMS simulation units 120 may be electrically connected by a desired number to the RBMS 200. The present disclosure is not necessarily limited to the case where a plurality of battery packs P are connected, and in some cases, it may be possible to inspect a battery pack P with the switch 150.

Additionally, a plurality of battery packs P as shown in Fig. 1 may be realized in various numbers in an actual environment. In this case, even if a battery pack simulator 100 having a different number of BMS simulation units 120 in correspondence to a different number of battery packs P is not provided one by one, all or part of the plurality of BMS simulation units 120 can be selected through the selector 160 and connected to the RBMS 200 as shown in Fig. 5.

In addition, not only the selector 160 can be used to select the number of BMS simulation units 120 electrically connected between the plurality of BMS simulation units 120, but also to select series or parallel connections between BMS simulation units 120.

In summary, according to embodiments of the present disclosure, one battery pack simulator 100 can be used to simulate various actual environments by varying the number of battery packs P.

Again, according to the embodiments of Figs, 2, 4, and 5, each of the plurality of BMS simulation units 120 and each of the plurality of connectors 130 may be individually detached from the substrate 140. In addition, when a plurality of cell simulation units 110 are integrated and disposed on the substrate 140, each cell simulation unit 110 may be individually detached from the substrate 140. Therefore, when an abnormality (failure) occurs in some of the cell simulation units 110, the BMS simulation units 120, and the connectors 130, it is possible to replace only the cell simulation unit 110 in which an abnormality has occurred, the BMS simulation unit 120 in which an abnormality has occurred, or the connector 130 in which an abnormality has occurred.

In addition, when it is desired to inspect a case where more battery packs are connected than the number of battery packs P that can be inspected with one battery pack simulator 100, it is possible to achieve this by electrically connecting a plurality of battery pack simulators 100 to each other.

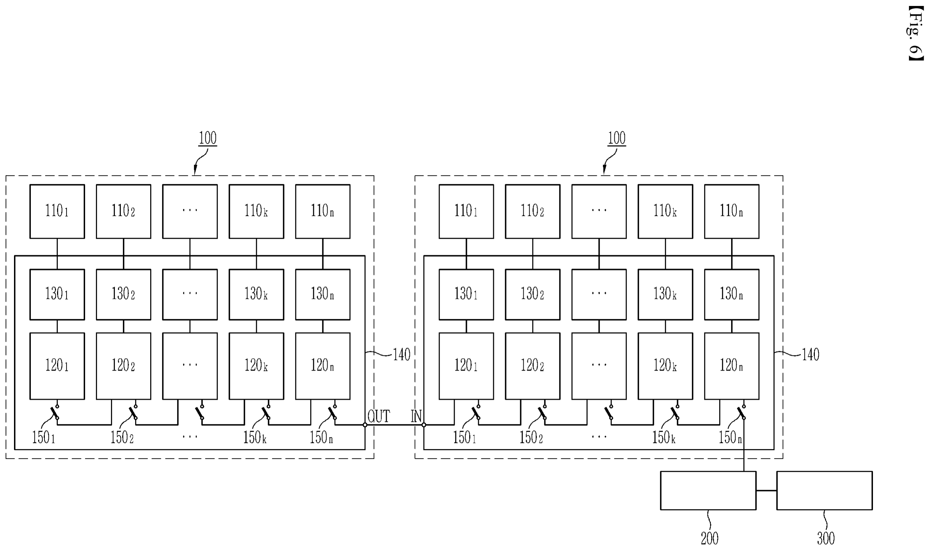

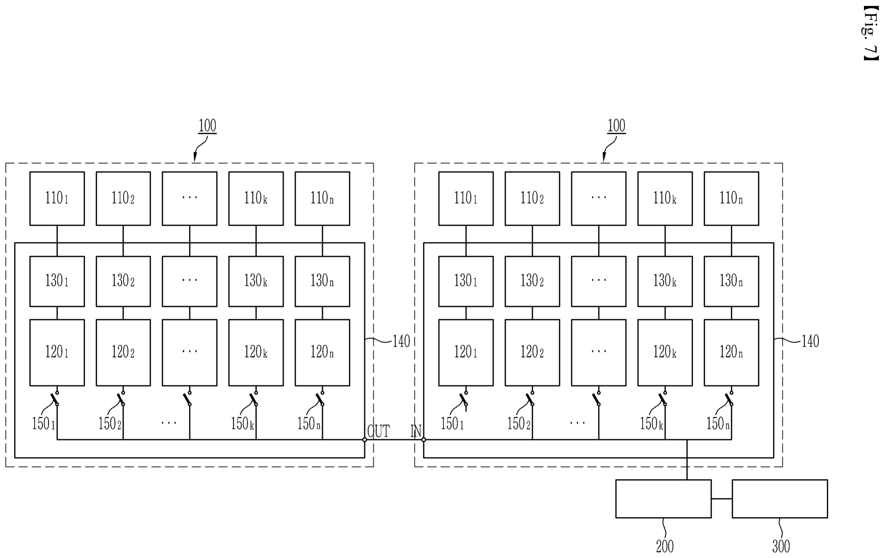

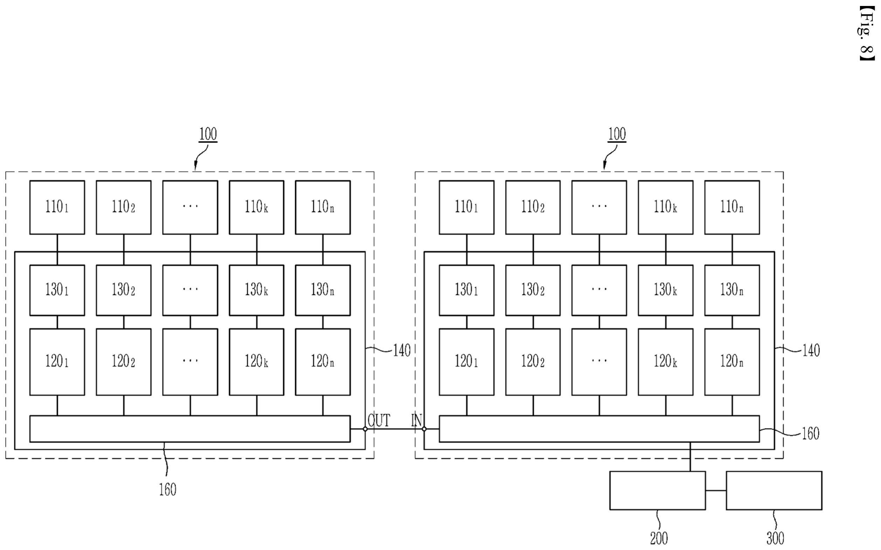

Figs. 6 to 8 respectively show a case where the simulators of Figs. 2, 4 and 5 are connected in a plurality of numbers. Figs. 6 to 8 exemplarily show a case where two simulators 100 are connected.

For example, if one battery pack simulator 100 is equipped with seven cell simulation units 110, seven BMS simulation units 120, and seven connectors 130, for example, if it is desired to inspect a case where 3 battery packs are connected, or a case where 5 battery packs are connected, the inspection can be performed by connecting the BMS simulation units 120 by the number of battery packs to be inspected using the switch 150 or selector 160 as described above in Figs. 2 to 5. However, if it is desired to inspect a case where nine battery packs are connected by way of example, two battery pack simulators 100 can be connected and nine BMS simulation units 120 can be connected to each switch 150 or selector 160 as shown in FIGS. 6 to 8.

In summary, the inspection device 300 can be connected to the battery pack simulator 100 described above in the embodiment of Figs. 2 to 5 instead of the actual battery pack P as shown in Fig. 1, thereby capable of inspecting battery packs P which are electrically connected by the desired number. As the types of inspections that can be performed by connecting the inspection device 300 to the battery pack simulator 100, for example, SOC measurement, cell voltage measurement, cell voltage deviation measurement, battery pack voltage measurement, temperature measurement with a thermistor, BMS function inspection, communication, and the like can be performed similarly by connecting the inspection device 300 to an actual battery pack (i.e., battery pack with actual cell module assembly and actual BMS). Inspection can be performed by connecting the inspection device 300 to the BMS simulation unit 120 of the battery pack simulator 100, and inspection may be performed via the RBMS 200 between the BMS simulation unit 120 and the inspection device 300. In addition, a switch 150 or selector 160 may be provided in the path between the BMS simulation unit 120 and the inspection device 300 as described above to inspect the battery packs P which are electrically connected by the desired number. In some cases, one battery pack P may be inspected using the switch 150 or the selector 160.

Although the invention has been described in detail with reference to preferred embodiments thereof, the scope of the present disclosure is not limited thereto, and various modifications and improvements can be made by those skilled in the art using the basic concepts of the present disclosure, which are defined in the appended claims, which also falls within the scope of the present disclosure.

### [Description of Reference Numerals]

100: battery pack simulator
110: cell simulation unit
120: BMS simulation unit
121: cell voltage control unit
122: pack voltage control unit
123: current control unit
124: temperature control unit
125: defect determination unit
126: SOH calculation unit
127: SOC calculation unit
128: arithmetic unit
129: transmission/reception unit
130: connector
140: substrate
150: switch
160: selector
200: RBMS
300: inspection device

## Claims

1. A battery pack simulator which simulates a battery pack including a cell module assembly(CMA) including a plurality of battery cell stacks and a battery management system(BMS), the battery pack simulator comprising:
a plurality of BMS simulation units that simulate the BMS,
wherein each BMS simulation unit manages and controls the state and operation of the battery pack to be simulated.

2. The battery pack simulator of claim 1, wherein:
the plurality of BMS simulation units are connected to each other in series and/or parallel, and are integrated and disposed on a substrate, and
each of the plurality of BMS simulation units can be selectively connected by a switch or a selector so as to enable adjustment of the number of battery packs to be simulated and of the series and/or parallel connections.

3. The battery pack simulator of claim 2, wherein:
each of the plurality of BMS simulation units can be electrically connected to a cell simulation unit for simulating the CMA, and manages and controls the state and operation of the cell simulation unit that performs the simulating,
the battery pack simulator further comprises a plurality of connectors that electrically connect each BMS simulation unit and each cell simulation unit, and
the plurality of connectors are integrated and disposed on the substrate.

4. The battery pack simulator of claim 3, wherein:
each BMS simulation unit and each cell simulation unit are detachable from the substrate.

5. The battery pack simulator of claim 3,
further comprising the plurality of cell simulation units that simulate the CMA,
wherein the plurality of cell simulation units are integrated and disposed on the substrate.

6. The battery pack simulator of claim 5, wherein:
each cell simulation unit is detachable from the substrate.

7. The battery pack simulator of claim 1, wherein:
an inspection device that inspects the battery pack can be directly or indirectly connected to the BMS simulation unit.

8. The battery pack simulator of claim 7, wherein:
a RBMS (Rack Battery Management System) that wholly manages and controls the plurality of battery packs is connected directly or indirectly to the BMS simulation unit, and an inspection device that inspects the battery packs is connected to the RBMS.

9. The battery pack simulator of claim 7, wherein:
the BMS simulation unit receives state information of a battery pack including at least one of the voltage of the battery cell in the CMA, the voltage of the battery pack, the current of the battery pack, and the temperature of the battery pack, and transmits the information to the inspection device.

10. The battery pack simulator of claim 7, wherein:
the BMS simulation unit receives state information of a battery pack including at least one of the voltage of the battery cell in the CMA, the voltage of the battery pack, the current of the battery pack, and the temperature of the battery pack, and changes the information in conformity with inspection conditions or generates state information of the battery pack in conformity with inspection conditions.

11. The battery pack simulator of claim 1, wherein:
the BMS simulation unit comprises at least one of a cell voltage control unit that controls the output of individual battery cells, a pack voltage control unit that controls the output of pack voltage, a current control unit that controls the output of current, and a temperature control unit that controls the output of temperature.

12. The battery pack simulator of claim 11, wherein:
the BMS simulation unit further comprises at least one of an SOH calculation unit that calculates an SOH estimate value, and a SOC calculation unit that calculates a SOC estimate value.

13. The battery pack simulator of claim 12, wherein:
the BMS simulation unit further comprises a defect determination unit that compares the cell voltage value, pack voltage value, current value, temperature value, SOH, or SOC with a predetermined reference value to determine whether the battery pack is defective or not.

14. The battery pack simulator of claim 12, wherein:
the BMS simulation unit further comprises an arithmetic unit that calculates the average value or deviation or remaining charge time for each of the cell voltage value, pack voltage value, current value, temperature value, SOH, and SOC.

15. The battery pack simulator of claim 12, wherein:
the BMS simulation unit further comprises a transmission/reception unit that communicates between the cell simulation unit and the inspection device.

16. The battery pack simulator of claim 1, wherein:
the battery pack simulators are provided in a plurality of numbers, and can be electrically connected in series or parallel between the battery pack simulators.
